# EUROPEAN PATENT APPLICATION

(11) **EP 2 410 573 A1**
(43) Date of publication of application: **25.01.2012**
(21) Application number: 10753296.2
(22) Date of filing: 17.03.2010
(51) Int. Cl.: H01L 31/042, H01L 31/04

(54) **SOLAR CELL MODULE**

(30) Priority: 18.03.2009 JP 2009065897
(71) Applicant: Fuji Electric Co., Ltd., Kawasaki-shi 210-9530 (JP)
(72) Inventor: YOKOYAMA, Yasuhiro, Tokyo 141-0032 (JP); HAYASHI, Kazuhiko, Tokyo 141-0032 (JP)
(74) Representative: MERH-IP Matias Erny Reichl Hoffmann
(86) International application number: PCT/JP2010/001911
(87) International publication number: WO 2010/106799

(57) **Abstract**

A solar cell module (100) includes a solar cell power generating unit (102) and a connecting member (104). The connecting member (104) supplies the output of a solar cell (110) to an external electronic component (220). The connecting member (104) includes a covering member (130) and an output connecting portion (140). The covering member (130) covers at least the surface of a terminal portion (126) among the surfaces of the terminal portion (126) and a protective member (120). The output connecting portion (140) has one end (142) disposed in the covering member (130) and the other end (144) disposed outside the covering member (130). The one end (142) of the output connecting portion 140 is connected to the terminal portion (126) of the solar cell power generating unit (102). The other end (144) of the output connecting portion (140) has a terminal for connection to an electronic component (200).

## Description

### TECHNICAL FIELD

The present invention relates to a solar cell module with high portability.

### BACKGROUND ART

In recent years, in order to protect the environment, solar cells have been widely spread. For example, there are a solar cell that has a large area in order to obtain a large output and a portable solar cell (for example, Patent Document 1). Patent Document 1 discloses a technique in which a solar cell module is provided so as to be attached to or detached from a portable power supply body. The portable power supply body has a shape that covers four sides and the bottom of the rectangular solar cell module.

Patent Document 2 discloses a structure in which a solar cell is provided on the external surface of a housing of a carrying case of an electronic apparatus.

Patent Document 3 discloses a structure in which a solar cell module is put into a plastic case, a rechargeable battery provided in the plastic case is charged by the solar cell module, and an electric outlet is connected to the rechargeable battery through a wiring line.

### CITATION LIST

### PATENT DOCUMENT

Patent Document 1: Japanese Patent Application Laid-Open (JP-A) No. 2006-24777
Patent Document 2: JP-A-63-164278
Patent Document 3: JP-A-2004-88043

### DISCLOSURE OF THE INVENTION

### PROBLEMS TO BE SOLVED BY THE INVENTION

In recent years, portable electronic apparatuses have been widely spread. Therefore, when the portability of the solar cell module is further improved, it is expected that a chance to use the solar cell module as a power supply of the portable electronic apparatus would increase. However, since the solar cell module disclosed in Patent Document 3 has the rechargeable battery therein, it is difficult to obtain sufficient portability.

The invention has been made in view of the above-mentioned problems and an object of the invention is to provide a solar cell module with high portability.

### MEANS FOR SOLVING THE PROBLEM

According to an aspect of the invention, a solar cell module includes a solar cell, a protective member, and a connecting portion. The protective member has the solar cell held therein and includes at least one side. The connecting portion extracts the output of the solar cell. Specifically, the connecting portion includes a terminal portion, a lead line, and an output connecting portion. The terminal portion is provided at one side of the protective member. The lead line is connected to the solar cell and is covered with the protective member and the terminal portion so as to be insulated. The output connecting portion is electrically connected to the lead line in the terminal portion and has a connection terminal connected to an external power supply adapter at one end thereof.
The end of the output connecting portion may be a two-core connector that can be connected to the power supply adapter.

According to another aspect of the invention, a solar cell module includes a solar cell, a protective member, and a connecting portion. The protective member is flexible and has the solar cell held therein. The connecting portion extracts the output of the solar cell. Specifically, the connecting portion includes a lead line, a through contact, and a wiring line. The lead line is connected to the solar cell and is held in the protective member. The through contact passes through the protective member and comes into contact with the lead line. The wiring line connects the through contact and a connection terminal connected to an external power supply adapter.

### ADVANTAGES OF THE INVENTION

According to the invention, it is possible to provide a solar cell module with high portability.

### BRIEF DESCRIPTION OF DRAWINGS

Fig. 1 is a perspective view illustrating the structure and usage of a solar cell module according to a first embodiment.
Fig. 2 is a plan view illustrating a main part of the solar cell module.
Fig. 3 is a cross-sectional view taken along the line A-A' of Fig. 2.
Fig. 4 is a plan view illustrating the structure of a solar cell module according to a second embodiment.
Fig. 5 is a plan view illustrating the structure of a solar cell module according to a third embodiment.
Fig. 6 is a plan view illustrating the structure of a solar cell module according to a fourth embodiment.
Fig. 7 is a perspective view illustrating the structure of a main part of a solar cell module according to a fifth embodiment.
Fig. 8 is a perspective view illustrating the structure of a main part of a solar cell module according to a sixth embodiment.
Fig. 9 is a perspective view illustrating a main part of a solar cell module according to a seventh embodiment.
Fig. 10 is a perspective view illustrating the structure of a power generating unit of the solar cell module.
Fig. 11 is a perspective view illustrating the usage of a solar cell module according to an eighth embodiment.
Fig. 12 is a plan view illustrating the structure of a solar cell module according to a ninth embodiment.
Figs. 13(a) and 13(b) are cross-sectional views taken along the line B-B' of Fig. 12.
Fig. 14 is a cross-sectional view illustrating the structure of a solar cell module according to a tenth embodiment.
Fig. 15 is a plan view illustrating the structure of a solar cell module according to an eleventh embodiment.
Fig. 16 is a plan view illustrating the structure of a solar cell module according to a twelfth embodiment.

### BEST MODE FOR CARRYING OUT THE INVENTION

Hereinafter, exemplary embodiments of the invention will be described with reference to the accompanying drawings. In all of the drawings, the same components are denoted by the same reference numerals and a description thereof will not be repeated.

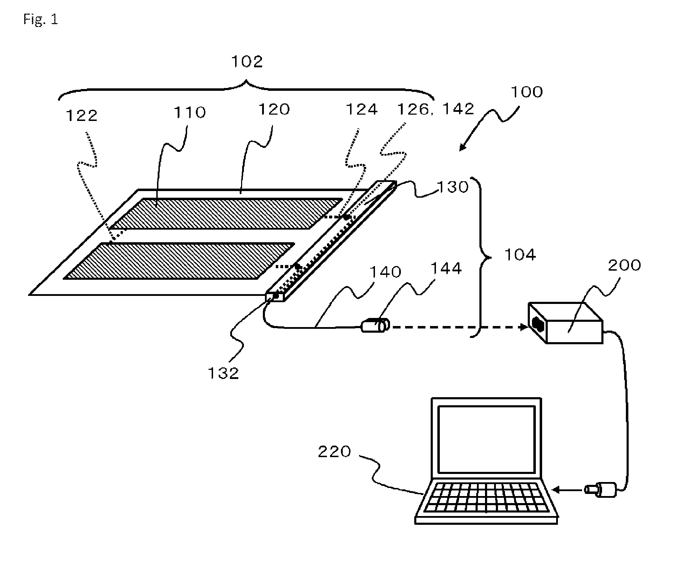

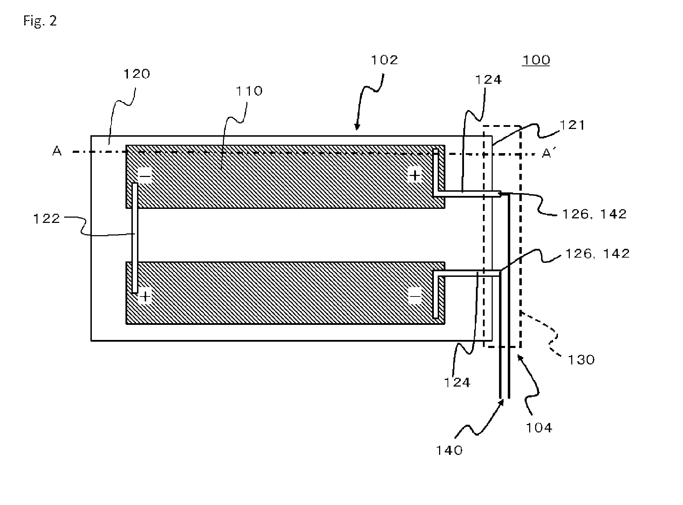

Fig. 1 is a perspective view illustrating the structure and usage of a solar cell module 100 according to a first embodiment. Fig. 2 is a plan view illustrating a main part of the solar cell module 100. The solar cell module 100 is a portable solar cell module and includes a solar cell power generating unit 102 and a connecting member 104.

The solar cell power generating unit 102 includes solar cells 110, a protective member 120, and a terminal portion 126. The solar cell 110 includes a substrate for forming a photoelectric conversion element and the photoelectric conversion element formed on the substrate. The protective member 120 has the solar cell 110 held therein. For example, the protective member 120 is formed by laminating two films, such as laminate films, with the solar cell 110 interposed therebetween. In this way, the protective member 120 protects both the front surface and the rear surface of the solar cell 110 and has at least one side. The front surface of the solar cell 110 is a light receiving surface. The terminal portion 126 is for extracting the output of the solar cell 110. The terminal portion 126 is provided at the edge (one side) of the protective member 120 and is connected to the solar cell 110 through a lead line 124 provided in the protective member 120.

The connecting member 104 supplies the output of the solar cell 110 to an external electronic component 200. In the example shown in Fig. 1, the electronic component 200 is an AC adapter of an electronic apparatus such as a portable computer. The connecting member 104 includes a covering member 130 and an output connecting portion 140. The covering member 130 covers at least the surface of the terminal portion 126 among the surfaces of the terminal portion 126 and the protective member 120.
The covering member 130 is formed by, for example, resin molding. It is preferable that the covering member 130 be not flexible.

The output connecting portion 140 includes an output line. A portion of the output line including one end 142 is disposed in the covering member 130 and the other end 144, which is an output end of the output line, is disposed outside the covering member 130. The one end 142 of the output connecting portion 140 is connected to the terminal portion 126 and is then connected to the solar cell 110 through the terminal portion 126 and the lead line 124. In addition, the other end 144 of the output connecting portion 140 has a terminal for connection to the electronic component 200. The terminal is a two-core connector that can be connected to the power supply adapter and is based on a standard defined by, for example, IEC 60320/J60320. The electronic component 200 is, for example, an AC adapter of a portable electronic apparatus 220. The electronic apparatus 220 may be, for example, a notebook personal computer or other electronic apparatuses.

In this embodiment, the protective member 120 has a rectangular or square shape and the terminal portion 126 is provided at one side 121 of the protective member 120. In this case, as shown in Fig. 2, it is preferable that the covering member 130 be provided over the entire length of the one side 121 of the protective member 120.
It is preferable that the output connecting portion 140 extend from an end surface 132 (see Fig. 1) of the covering member 130 intersecting the one side 121 of the protective member 120 to the outside of the covering member 130.

The solar cell 110 may be a flexible thin-film solar cell or a non-flexible solar cell. When the solar cell 110 is flexible, the solar cell 110 is, for example, a thin-film solar cell in which a photoelectric conversion layer is formed on a flexible substrate.

When the solar cell 110 is flexible, it is preferable that the protective member 120 be also flexible. When the protective member 120 includes a front-side protective member and a rear-side protective member, a fluorine resin film made of, for example, polyethylene tetrafluoroethylene (ETFE), poly(trifluoroethylene), or polyvinyl fluoride is used as the front-side protective member. In addition to the above-mentioned materials, a thin metal plate, such as a steel plate, an aluminum plate, or a stainless plate, a plastic plate, or an FRP plate may be used as the rear-side protective member.

In this embodiment, the solar cell power generating unit 102 includes a plurality of solar cells 110 connected in series to each other. In this case, it is preferable that an output voltage be higher than the minimum voltage (for example, 90 V) of the effective value of a commercial AC power supply. In the example shown in Fig. 1, the solar cells 110 are connected in series to each other by wiring lines 122. The output of the solar cells 110 can be extracted from the terminal portion 126 by the lead lines 124. The lead line 124 is covered by the protective member 120 and the terminal portion 126 so as to be insulated.

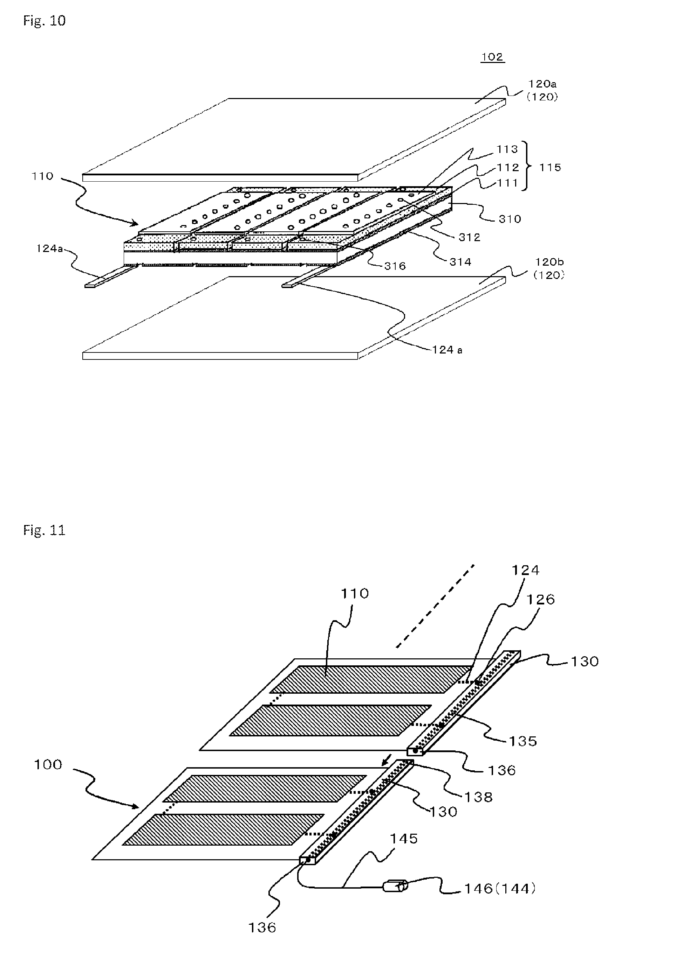

Fig. 10 is an exploded perspective view illustrating the structure of the solar cell power generating unit 102. The solar cell power generating unit 102 is a Series Connection through Aperture on Film (SCAF) type thin-film solar cell. Specifically, the solar cell power generating unit 102 includes the solar cell 110 having a substrate 310, a photoelectric conversion element 115, and a connection electrode layer 314, a lead line 124a, which is a conductive foil lead, and the protective member 120.

The substrate 310 is an insulating substrate made of, for example, polyimide, polyamide, polyimide-amide, polyethylene naphthalate (PEN), polyethylene terephthalate (PET), polyetherimide (PEI), polyether ether ketone (PEEK), or polyether sulfone (PES).

The photoelectric conversion element 115 includes a lower electrode layer 111, a photoelectric conversion layer 112, and a transparent electrode layer 113 sequentially formed on one surface of the substrate 310. The photoelectric conversion layer 112 is, for example, a microcrystalline silicon layer or an amorphous silicon layer. In addition, the connection electrode layer 314 is formed on the opposite surface (rear surface) of the substrate 310. A plurality of divided photoelectric conversion elements 115 and divided connection electrode layers 314 are arranged in parallel to form the solar cell 110.

The photoelectric conversion elements 115 are arranged as a plurality of divided blocks on one surface of the substrate 310 and the connection electrode layers 314 are arranged as a plurality of divided blocks on the opposite surface of the substrate 310. The blocks of the photoelectric conversion elements 115 and the blocks of the connection electrode layers 314 deviate from each other such that one of the block of the photoelectric conversion element 115 and the block of the connection electrode layer 314 overlaps the gap between the other blocks, in a plan view.

A plurality of through holes, which are power collection holes 312, are arranged in the solar cell 110 and the transparent electrode layer 113 and the connection electrode layer 314 are electrically connected to each other by a conductive film provided on the inner walls of the power collection holes 312.

A connection hole 316 is provided in a portion of the photoelectric conversion layer on which the transparent electrode layer 113 is not formed. The lower electrode layer 111 and the connection electrode layer 314 are electrically connected to each other by a conductive provided on the inner walls of the connection holes 316.

The power collection holes 312 and the connection holes 316 connect the divided connection electrode layer 314 to the block of an adjacent connection electrode layer 314, and the block of the connection electrode layer 314 to which the connection hole 316 is connected is connected to the power collection hole 312 of the block of an adjacent photoelectric conversion element 115. Therefore, adjacent blocks of the photoelectric conversion elements 115 are connected in series to each other.

The SCAF structure makes it possible to reduce the size of a multi-stage series connection structure while obtaining a sufficiently insulation performance. Therefore, it is possible to obtain a high voltage (about 100 V) from a small solar cell module.

The lead line 124a, for example, a copper foil lead line, is drawn from the other surface (in Fig. 10, the lower surface) of the substrate 310 to the outside of the substrate 310, and transmits the output of the solar cell 110 to the terminal portion 126. Specifically, two lead lines 124a are connected to the blocks of the connection electrode layers 314 disposed at both ends of the substrate 310.

A portion of the lead line 124a that is drawn to the outside of the substrate 310 is held in the protective member 120. That is, the portion of the lead line 124a is interposed between the front-side protective member 120a and the rear-side protective member 120b. In this structure, in the protective members 120a and 120b, at least one surface that comes into contact with the lead line 124 has an insulating property. Therefore, even when the output voltage of the lead line 124 is high, it is possible to ensure an insulating property.

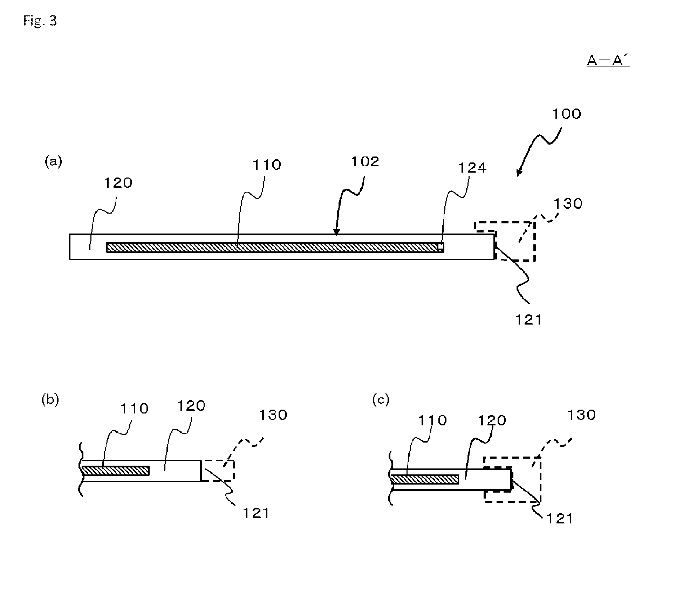

Fig. 3(a) is a cross-sectional view taken along the line A-A' of Fig. 2. In the example shown in Fig. 3(a), a portion of the covering member 130 of the connecting member 104 comes into contact with the end surface and the front surface of the solar cell power generating unit 102 at one side 121 of the protective member 120 of the solar cell power generating unit 102, but the covering member 130 does not come into contact with the rear surface of the solar cell power generating unit 102. That is, in the example shown in Fig. 3(a), the covering member 130 covers the upper surface and the side surface of the one side 121 of the protective member 120.

The covering member 130 may have other shapes. For example, as shown in Fig. 3(b), the covering member 130 may come into contact with only the end surface of the protective member 120 at the one side 121. As shown in Fig. 3(c), the covering member 130 may be configured so as to have the protective member 120 interposed between both sides thereof in the vertical direction at the one side 121. In the embodiment shown in Fig. 3(c), the covering member 130 covers the upper surface, the side surface, and the lower surface of the one side 121 of the protective member 120.

Next, the operation and effect of this embodiment will be described. In this embodiment, the lead line 124 is covered with the protective member 120 so as to be insulated and the terminal portion 126 (126a and 126b) is covered with the covering member 130 so as to be insulated. Therefore, even when the output voltage of the solar cell power generating unit 102 is high, it is possible to ensure the insulation of the lead line 124. As a result, it is possible to supply the output of the solar cell power generating unit 102 to the power supply adapter without any change.

The connecting member 104 for extracting the output of the solar cell power generating unit 102 is provided only in a portion of the edge of the solar cell power generating unit 102. Therefore, it is possible to reduce the size of the solar cell module 100. The connecting member 104 makes it possible to carry the solar cell module 100 without contacting the solar cell power generating unit 102. This effect is noticeable when the covering member 130 is provided so as to have the protective member 120 interposed between both sides thereof in the vertical direction, as shown in Fig. 3. Therefore, it is possible to improve the portability of the solar cell module 100.

When the protective member 120 of the solar cell power generating unit 102 has a rectangular or square shape and the covering member 130 of the connecting member 104 is provided over the entire length of the one side 121 of the protective member 120, it is easy to carry the solar cell module 100. When the output connecting portion 140 of the connecting member 104 extends from the end surface 132 of the covering member 130 which intersects the one side 121 of the protective member 120, the connecting member 104 can prevent the output connecting portion 140 from interfering with the hand of the user.

When both the solar cell 110 and the protective member 120 of the solar cell power generating unit 102 are flexible and the solar cell module 100 is carried, it is possible to wind the solar cell power generating unit 102 on the covering member 130 of the connecting member 104. Therefore, the portability of the solar cell module 100 is further improved.

When the other end 144 of the output connecting portion 140 of the connecting member 104 has a two-core connector that can be connected to a power supply adapter of an electronic apparatus, for example, a terminal based on a standard defined by IEC 60320/J60320, the other end 144 can be inserted into an AC adapter attached to the portable electronic apparatus 220, such as a notebook personal computer, without any change. Therefore, since the output of the solar cell module 100 is higher than the minimum voltage of the effective value of a commercial AC power supply, it is possible to use only the solar cell module 100 as the power supply (including a power supply for charging) of the electronic apparatus, without using another power supply adapter. In particular, when the electronic apparatus is carried and there is no commercial AC power supply in the neighborhood, the effect of using the solar cell module 100 as a power supply for the electronic apparatus is noticeable.

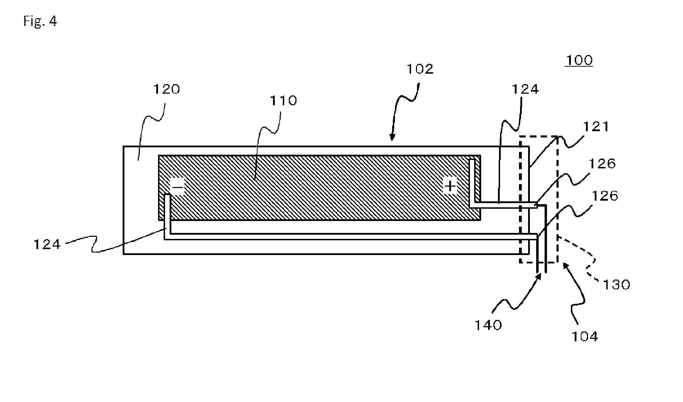

Fig. 4 is a plan view illustrating the structure of a solar cell module 100 according to a second embodiment. Fig. 4 corresponds to Fig. 2 in the first embodiment. The solar cell module 100 according to this embodiment has the same structure as that according to the first embodiment except that the solar cell power generating unit 102 includes only one solar cell 110.
In this embodiment, it is possible to obtain the same effect as that in the first embodiment.

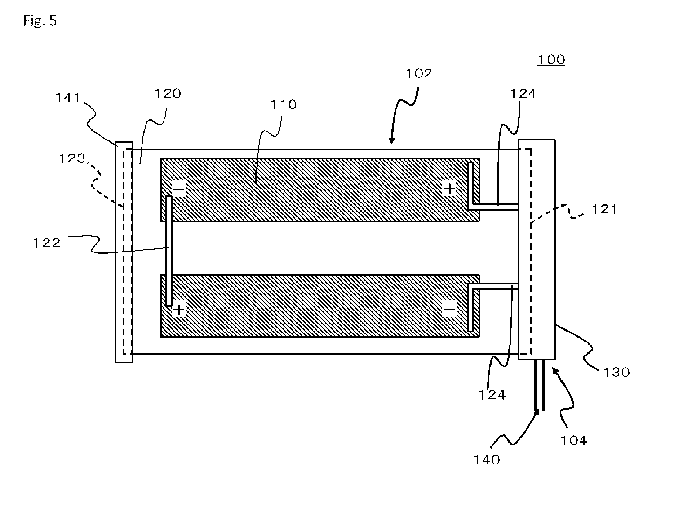

Fig. 5 is a plan view illustrating the structure of a solar cell module 100 according to a third embodiment. Fig. 5 corresponds to Fig. 2 in the first embodiment. The solar cell module 100 according to this embodiment has the same structure as that according to the first embodiment except that a weight 141 is provided in the solar cell power generating unit 102 having a square or rectangular shape. The weight 141 is provided at a side 123 of the protective member 120 of the solar cell power generating unit 102. The side 123 is opposite to the one side 121 where the connecting member 104 is provided. For example, the weight 141 has the protective member 120 interposed between both sides thereof in the vertical direction, similar to the covering member 130.

In this embodiment, it is possible to obtain the same effect as that in the first embodiment. When both the solar cell 110 and the protective member 120 are flexible, it is possible to wind the solar cell power generating unit 102 on the covering member 130 and carry the solar cell power generating unit 102. In this case, the solar cell power generating unit 102 is likely to be curled. In contrast, in this embodiment, the weight 141 is provided in the solar cell power generating unit 102. Therefore, even though the solar cell power generating unit 102 is curled, it is possible to easily uncurl the solar cell power generating unit 102 when the solar cell module 100 is used.

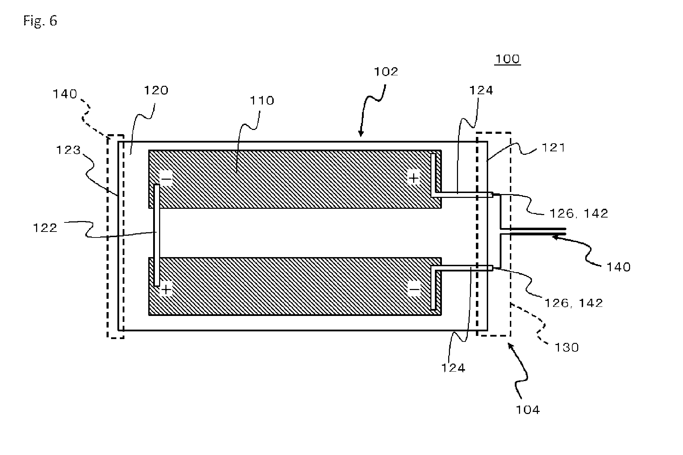

Fig. 6 is a plan view illustrating the structure of a solar cell module 100 according to a fourth embodiment. Fig. 6 corresponds to Fig. 5 in the third embodiment. The solar cell module 100 according to this embodiment has the same structure as the solar cell module 100 according to the third embodiment except that the output connecting portion 140 of the connecting member 104 extends from the side surface of the covering member 130 which is parallel to the one side 121 of the protective member 120 to the outside.
In this embodiment, it is possible to obtain the same effect as that in the third embodiment.

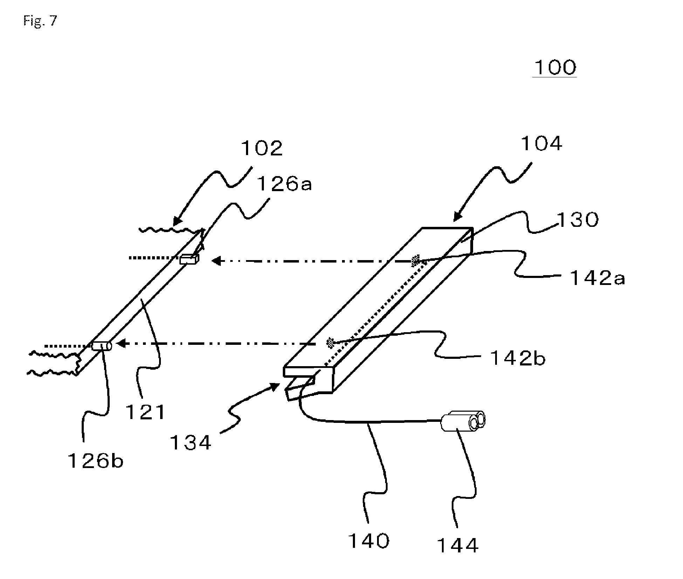

Fig. 7 is a perspective view illustrating the structure of a main part of a solar cell module 100 according to a fifth embodiment. The solar cell module 100 according to this embodiment has the same structure as the solar cell module 100 according to the first embodiment except that the connecting member 104 is removable from the solar cell power generating unit 102.

In this embodiment, the solar cell power generating unit 102 has terminal portions 126a and 126b on an end surface forming the one side 121 of the protective member 120. The terminal portions 126a and 126b have different cross-sectional shapes.

The covering member 130 of the connecting member 104 has a concave portion 134 which is formed in an end surface facing the one side 121 of the protective member 120 and into which the one side 121 is inserted. Terminals 142a and 142b into which the terminal portions 126a and 126b are inserted are formed in the bottom of the concave portion 134. The terminals 142a and 142b form one end of the output connecting portion 140. As described above, since the terminal portions 126a and 126b have different cross-sectional shapes, the terminals 142a and 142b also have different cross-sectional shapes.

In this embodiment, it is possible to obtain the same effect as that in the first embodiment. In addition, since the connecting member 104 can be removed from the solar cell power generating unit 102, the portability of the solar cell module 100 is further improved.

Since the terminal portions 126a and 126b have different cross-sectional shapes, it is possible to prevent the connecting member 104 from being attached to the solar cell power generating unit 102 in a different direction.

In Fig. 7, the terminal portions 126a and 126b are mail terminals and the terminals 142a and 142b are female terminals. However, the terminal portions 126a and 126b may be female terminals and the terminals 142a and 142b may be male terminals.

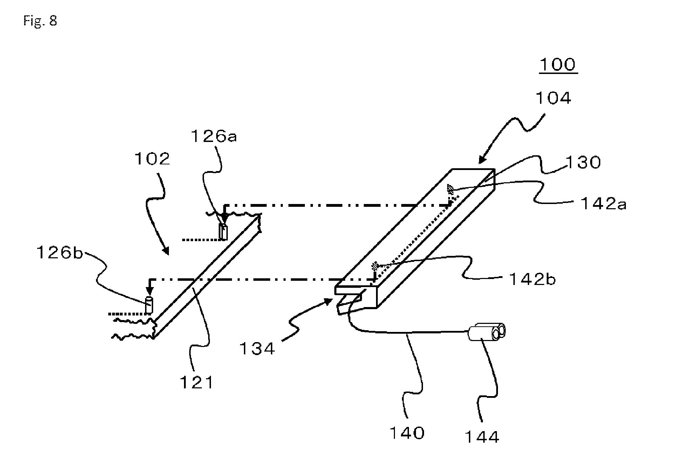

Fig. 8 is a perspective view illustrating the structure of a main part of a solar cell module 100 according to a sixth embodiment. Fig. 8 corresponds to Fig. 7 in the fifth embodiment. The solar cell module 100 according to this embodiment has the same structure as the solar cell module 100 according to the fifth embodiment except for the following points.

First, the terminal portions 126a and 126b of the solar cell power generating unit 102 are provided on the upper surface of the protective member 120. The terminals 142a and 142b of the connecting member 104 are provided in the upper surface of the concave portion 134 in Fig. 8.

In this embodiment, it is possible to obtain the same effect as that in the fifth embodiment. With the connecting member 104 attached to the solar cell power generating unit 102, the connecting member 104 is less likely to be taken off from the solar cell power generating unit 102.

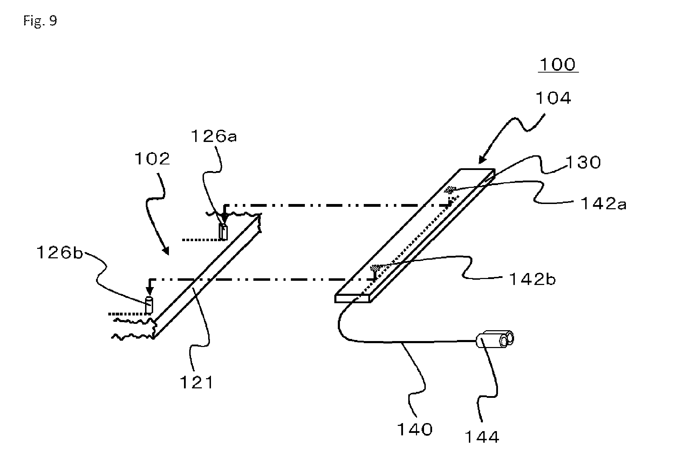

Fig. 9 is a perspective view illustrating a main part of a solar cell module 100 according to a seventh embodiment. Fig. 9 corresponds to Fig. 8 in the sixth embodiment. The solar cell module 100 according to this embodiment has the same structure as the solar cell module 100 according to the sixth embodiment except for the structure of the covering member 130 of the connecting member 104.

In this embodiment, the covering member 130 does not have the concave portion 134 shown in Fig. 7. The terminals 142a and 142b are provided in the lower surface of the covering member 130. The covering member 130 is attached to the upper surface of the solar cell power generating unit 102. That is, in this embodiment, the covering member 130 covers the upper surface of one side 121 of the protective member 120.

In this embodiment, it is possible to obtain the same effect as that in the fifth embodiment. In addition, it is easy to attach or detach the connecting member 104 to or from the solar cell power generating unit 102.

Fig. 11 is a perspective view illustrating the usage of a solar cell module 100 according to an eighth embodiment. Fig. 11 corresponds to Fig. 1 in the first embodiment. The solar cell module 100 according to this embodiment has the same structure as the solar cell module 100 according to any one of the first to seventh embodiments.

First, a first connector 136 is provided at one end of the covering member 130 and a second connector 138 is provided at the other end of the covering member 130. The second connector 138 has a shape different from that of the first connector 136 and is coupled to the first connector 136.

Two wiring lines 135 are provided in the covering member 130. Each of the two wiring lines 135 has one end that is disposed in the first connector 136 and the other end that is disposed in the second connector 138.
The terminal portion 126 of the lead line 124 is connected between the one end and the other end of the wiring line 135. That is, one of the wiring lines 135 is connected to one of two lead lines 124 and the other wiring line 135 is connected to the other lead line 124. The two wiring lines 135 serve as output lines of the solar cell 110.

A wiring line 145 can be connected to the first connector 136. A terminal 146 for connection to the electronic component 200 is attached to the end of the wiring line 145. The terminal 146 has the same structure as the terminal provided at the other end 144 in the first embodiment.

In this structure, when the first connector 136 of the first solar cell module 100 is coupled to the second connector 138 of the second solar cell module 100, the wiring lines 135 of the first solar cell module 100 are connected to the wiring lines 135 of the second solar cell module 100, and the first solar cell module 100 and the second solar cell module 100 are connected in parallel to each other.

Therefore, according to this embodiment, it is possible to obtain the same effect as that of the first to seventh embodiments and increase the power supply capacity of the solar cell module 100.

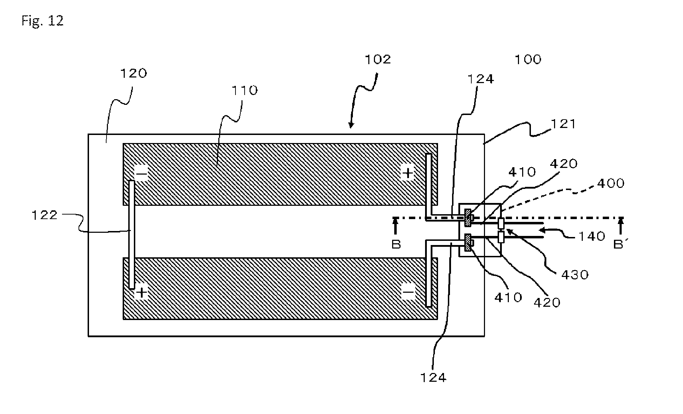

Fig. 12 is a plan view illustrating the structure of a solar cell module 100 according to a ninth embodiment.
The solar cell module 100 according to this embodiment has the same structure as the solar cell module 100 according to any one of the first to fourth embodiments except for a structure for extracting the output of the solar cell 110.

First, the entire lead line 124 is covered with the protective member 120. The output of the solar cells 110 is connected to the output lines of the output connecting portion 140 through two through contacts 410 that pass through the protective member 120.

Specifically, the two through contacts 410 are provided in one housing 400. Connectors 430 are provided on the side surface of the housing 400 and are connected to the output lines of the output connecting portion 140. The connectors 430 and the through contacts 410 are connected to each other through wiring lines 420 provided in the housing 400.

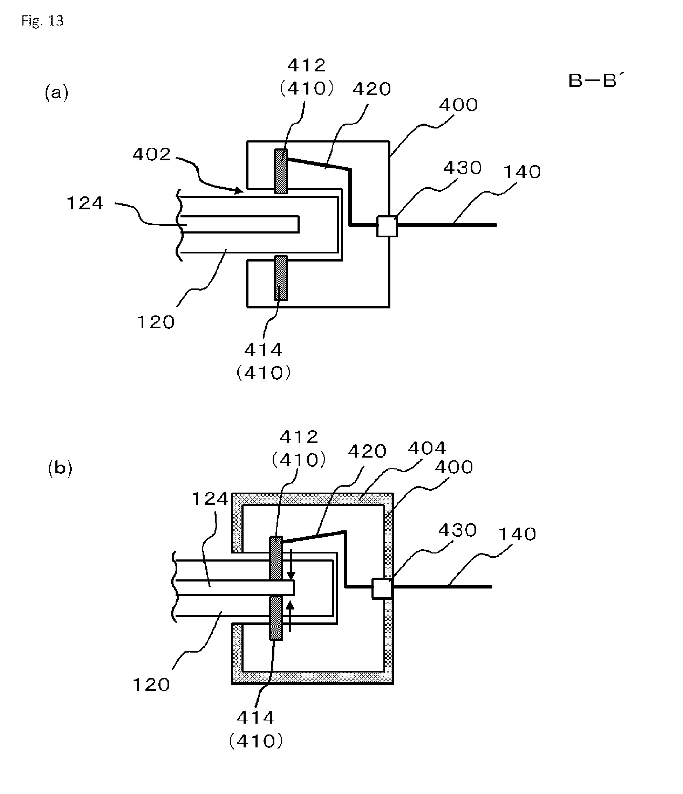

Figs. 13(a) and 13(b) are cross-sectional views taken along the line B-B' of Fig. 12 and show the arrangement and movement of the through contacts 410.

As shown in Fig. 13(a), the housing 400 includes a concave portion 402 and the concave portion 402 has a shape in which the end of the protective member 120 is inserted into the concave portion 402. The through contact 410 is provided in a region facing the protective member 120 in the inner surface of the concave portion 402 of the housing 400 so as to be movable in a direction in which it is pushed to the protective member 120.

Specifically, the through contact 410 includes two through contacts 412 and 414. The through contacts 412 and 414 are provided in two inner surfaces of the concave portion 402 which face each other. The through contacts 412 and 414 are provided at a position where they face each other with the lead line 124 interposed therebetween, when the protective member 120 is inserted into the concave portion 402.

As shown in Fig. 13(b), the through contact 412 is pushed from one surface of the protective member 120 to the protective member 120 and the through contact 414 is pushed from the other surface of the protective member 120 to the protective member 120. Since the protective member 120 is flexible, the through contacts 412 and 414 are inserted into the protective member 120 and the lead line 124 is directly interposed between the through contacts 412 and 414. In this way, the through contacts 412 and 414 are connected to the lead line 124.

After the through contacts 412 and 414 are connected to the lead line 124, an insulating cap member 404 is attached to the housing 400. The cap member 404 has a shape that covers the outside of the housing 400. In this way, even when the housing 400 is electrically connected to the through contacts 412 and 414 or the wiring line 420, the user does not receive an electric shock.

In this embodiment, it is possible to obtain the same effect as that in the first embodiment.

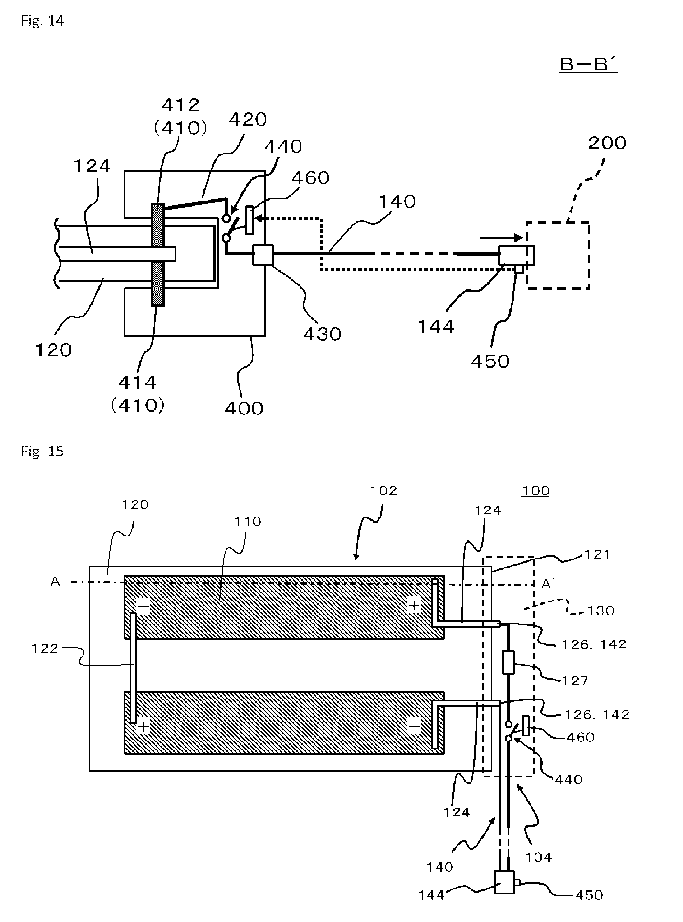

Fig. 14 is a cross-sectional view illustrating the structure of a solar cell module 100 according to a tenth embodiment and corresponds to Fig. 13 in the ninth embodiment. The solar cell module 100 according to this embodiment has the same structure as the solar cell module 100 according to the ninth embodiment except that it includes a switching element 440, a detecting unit 450, and a switching control unit 460.

The switching element 440 is provided between the lead line 124 and the other end 144 of the positive wiring line 420 at which a connection terminal is provided. The switching element 440 turns on or off the connection between the through contact 412 and the connector 430.

The detecting unit 450 is provided at the connection terminal of the other end 144 of the output connecting portion 140 and detects the connection of the connection terminal to an electronic component 200 such as a power supply adapter. The detecting unit 450 is, for example, a protruding switching element. When the connection terminal is connected to the electronic component 200, the protruding portion is pressed by the electronic component 200 and the detecting unit 450 detects that the connection terminal is connected to the electronic component 200. The detecting unit 450 also detects the disconnection of the connection terminal from the electronic component 200.

The switching control unit 460 is provided in the housing 400. When the detecting unit 450 detects that the connection terminal is connected to the electronic component 200, the switching control unit 460 turns on the switching element 440. When the detecting unit 450 detects that the connection terminal is disconnected from the electronic component 200, the switching control unit 460 turns off the switching element 440. The detection result of the detecting unit 450 is transmitted to the switching control unit 460 by, for example, wireless communication.

In this embodiment, it is possible to obtain the same effect as that in the ninth embodiment. In addition, since the switching element 440 is turned on when the connection terminal is connected to the electronic component 200, the stability of the solar cell module 100 is improved.

Fig. 15 is a plan view illustrating the structure of a solar cell module 100 according to an eleventh embodiment. The solar cell module 100 has the same structure as the solar cell modules 100 according to any one of the first to fourth embodiments or the eighth embodiment except for the following points.

First, an overpower protection circuit 127 is provided in the covering member 130. The overpower protection circuit 127 is provided between the lead line 124 and the other end 144 of the output connecting portion 140 and protects the electronic component 200 (shown in Fig. 1) and the electronic apparatus 220 (shown in Fig. 1) from overpower, for example, overvoltage or overcurrent. The overpower protection circuit 127 is, for example, a switch fuse.

In addition, the switching element 440 and the switching control unit 460 are provided in the covering member 130, and the detecting unit 450 is provided at a connection terminal of the other end 144 of the output connecting portion 140. The switching element 440, the detecting unit 450, and the switching control unit 460 have the same structure as those in the tenth embodiment.

In this embodiment, it is possible to obtain the same effect as that in the first embodiment. In addition, since the overpower protection circuit 127 is provided, it is possible to protect the electronic component 200 and the electronic apparatus 220 from overvoltage or overcurrent.

Similar to the tenth embodiment, the switching element 440 is turned on when the connection terminal is connected to the electronic component 200. Therefore, the stability of the solar cell module 100 is improved.

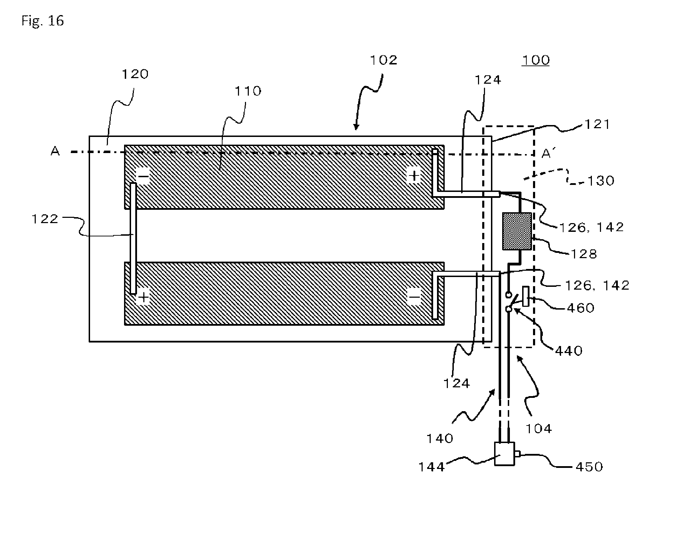

Fig. 16 is a plan view illustrating the structure of a solar cell module 100 according to a twelfth embodiment. The solar cell module 100 according to this embodiment has the same structure as the solar cell module 100 according to the eleventh embodiment except that it includes a power supply stabilizing circuit 128 instead of the overpower protection circuit 127.

The power supply stabilizing circuit 128 is, for example, a power conditioner. When the output voltage of the solar cell module 100 is higher than a rated voltage, the power supply stabilizing circuit 128 reduces the voltage. When the output voltage is lower than the rated output, the power supply stabilizing circuit 128 stops outputting.

In this embodiment, it is possible to obtain the same effect as that in the first embodiment. In addition, since the power supply stabilizing circuit 128 is provided, it is possible to stabilize the output of the solar cell module 100.

The embodiments of the invention have been described above with reference to the drawings. However, the embodiments of the invention are illustrative and various structures other than the above-described embodiments may be used.

Priority is claimed on Japanese Patent Application No. 2009-065897, filed March 18, 2009, the content of which is incorporated herein by reference.

## Claims

1. A solar cell module comprising:
a solar cell;
a protective member that has the solar cell held therein and includes at least one side; and
a connecting portion that extracts the output of the solar cell,
wherein the connecting portion includes:
a terminal portion that is provided at one side of the protective member;
a lead line that is connected to the solar cell and is covered with the protective member and the terminal portion so as to be insulated; and
an output connecting portion that is electrically connected to the lead line in the terminal portion and has a connection terminal connected to an external power supply adapter at one end thereof.

2. The solar cell module according to claim 1,
wherein the connection terminal is a two-core connector that can be connected to the power supply adapter.

3. The solar cell module according to claim 3, further comprising:
a covering member that is provided over the entire length of the one side of the protective member.

4. The solar cell module according to claim 3,
wherein the output connecting portion extends from an end surface of the covering member which intersects the one side to the outside of the covering member.

5. The solar cell module according to any one of claims 2 to 4,
wherein the solar cell is a flexible thin-film solar cell, and
the protective member is flexible.

6. The solar cell module according to any one of claims 1 to 5,
wherein the solar cell module includes a plurality of the solar cells connected in series to each other, and
an output voltage is higher than a minimum voltage of an effective value of a commercial AC power supply.

7. The solar cell module according to any one of claims 1 to 6,
wherein the solar cell includes a plurality of divided photoelectric conversion units that is formed on one surface of an insulating substrate and is connected in series to each other,
the lead line is drawn from the other surface of the substrate to the outside of the substrate of the solar cell and transmits the output of the photoelectric conversion unit to the output connecting portion,
the protective member has an insulating property, and a portion of the lead line that is drawn to the outside of the substrate is held in the protective member.

8. The solar cell module according to any one of claims 1 to 7,
wherein the connecting portion includes:
a covering member that is provided so as to extend from one end of the one side of the protective member to the other end,
a first connector that is provided at one end of the covering member;
a second connector that is provided at the other end of the covering member and is coupled to the first connector; and
a wiring line that is a portion of the output connecting portion, has one end disposed in the first connector and the other end disposed in the second connector, and is connected to the lead line between the one end and the other end, and
when the first connector of a first solar cell module and the second connector of a second solar cell module are connected to each other, the first solar cell module is connected in parallel to the second solar cell module.

9. A solar cell module comprising:
a solar cell;
a protective member that is flexible and has the solar cell held therein; and
a connecting portion that extracts the output of the solar cell,
wherein the connecting portion includes:
a lead line that is connected to the solar cell and is held in the protective member;
a through contact that passes through the protective member and comes into contact with the lead line; and
a wiring line that connects the through contact and a connection terminal connected to an external power supply adapter.

10. The solar cell module according to claim 9, further includes:
a housing including a concave portion into which the protective member is inserted,
wherein the through contact is provided in a region facing the protective member in the inner surface of the concave portion of the housing so as to be movable in a direction in which the through contact is inserted into the protective member.

11. The solar cell module according to claim 10, further comprising:
an insulating cap member that covers the surface of the housing.

12. The solar cell module according to any one of claims 1 to 11,
wherein the connecting portion includes:
a switching element that is provided between the connection terminal and the lead line;
a detecting unit that is provided at the connection terminal and detects that the connection terminal is connected to the power supply adapter; and
a switching control unit that turns on the switching element when the detecting unit detects that the connection terminal is connected to the power supply adapter.

13. The solar cell module according to any one of claims 1 to 12,
wherein the connecting portion includes an overpower protection circuit that is provided between the connection terminal and the lead line.

14. The solar cell module according to any one of claims 1 to 13,
wherein the connecting portion includes a power supply stabilizing circuit that is provided between the connection terminal and the lead line, reduces a voltage when an output voltage is higher than a rated voltage, and stops an output operation when the output voltage is lower than the rated voltage.
